# EUROPEAN PATENT APPLICATION

(11) **EP 4 155 472 A1**
(43) Date of publication of application: **29.03.2023**
(21) Application number: 20733496.2
(22) Date of filing: 20.05.2020
(51) Int. Cl.: E03D 5/10, G01D 21/00, H03K 17/955

(54) **SYSTEM AND METHOD FOR MANAGEMENT, CONTROL, AND PREDICTIVE MAINTENANCE IN INSTALLATIONS IN DAMP ROOMS AND FLUID DISTRIBUTION NETWORKS**

(71) Applicant: Ontech Security, S.L., 41309 La Rinconada (Sevilla) (ES)
(72) Inventor: APONTE LUIS, Juan, 41309 La Rinconada (Sevilla) (ES)
(74) Representative: Sahuquillo Huerta, Jesús
(86) International application number: PCT/ES2020/070325
(87) International publication number: WO 2021/234185

(57) **Abstract**

The invention relates to a system and method for management, control, and predictive maintenance in installations in damp rooms and fluid distribution networks, comprising the steps of: integrating an antenna (101, 101a...101e) inside at least one element installed in a damp room and/or fluid distribution network (3, 4, 5, 6, 7), wherein said antenna (101, 101a, ..., 101e) is configured for receiving the signal of an electromagnetic field generated around same; and wherein said antenna (101, 101a...101e) is connected with at least one controlled electromagnetic field sensor (100) configured for generating an electric and magnetic field around said antenna (101, 101a, ..., 101e); continuously measuring the variations in the electric and magnetic field generated around the antenna (101, 101a, ..., 101e); establishing a behavioral pattern of the installation in an element installed in a damp room and/or fluid distribution network (3, 4, 5, 6, 7); and selecting an action to be performed in the element installed in a damp room and/or fluid distribution network (3, 4, 5, 6, 7) depending on the established behavioral pattern.

## Description

### Technical field of the invention

The present invention relates to a system for management, control, and predictive maintenance in installations in damp rooms, as well as to a method for control, incident management, and predictive maintenance in fluid transport networks by means of using a sensor capable of measuring minimum changes of impedance generated around the sensor. This sensor is based on controlled electromagnetic field (CEMF) technology.

### State of the art

Damp rooms or premises are understood to be those rooms or installations environmental conditions of which momentarily or permanently appear in the form of condensation on the ceiling and walls, salt stains, or mold, when there are no droplets or when neither the ceiling nor the walls are impregnated with water. Typically, damp rooms are damp rooms or kitchens which comprise a series of apparatus, also typically electrically powered apparatus, such as hand dryers or paper dispensers, and which, due to their special conditions, also require specific technical determinants.

On the other hand, fluid distribution networks comprise either municipal water distribution network, such as potable water distribution networks, of any size and type, for example, the networks found in damp rooms for public and/or private use, or installations for the distribution of other fluids, such as pipe installations in refineries or gas distribution installations.

Various systems relating to presence detection in public bathrooms, such as urinals or restrooms, are described in the state of the art. For example, document DE19950874A1 describes a probe in the form of a proximity sensor, for example, for detecting a person using a urinal. The output signal of an electronic circuit depends on the capacitance of the probe. The actuator of a solenoid valve is controlled by means of the output signal. The control device works in pulsed mode and the probe is integrated in a microprocessor-controlled control circuit. The pulse width (t) is preferably 200 microseconds. The interval between pulses is from 0.5 to 1.0 s. Electrical power is supplied from a battery, a rechargeable battery, or a solar cell. On the other hand, document EP1936045A1 describes a sanitary device consisting of a basin having a sensor for flush mounting, this sensor being controlled by a control device.

Finally, document US3434164A describes an automatic flushing control system comprising voltage actuated proximity sensing means for sensing for the presence of a user at the urinal, first water control means responsive to said proximity-sensing means for starting a water flow at a first rate from a water supply through the urinal when a user approaches, and second water control means responsive to: said proximity-sensing means for starting a water flow at a second rate from the water supply through the urinal for a predetermined time after the user departs therefrom.

The described documents constitute only some of those documents which describe detection systems. Nevertheless, all these documents have the same defects. First, all the documents found are based on presence detectors employing different technologies. Most of the detectors used today in public bathrooms are optical detectors. The problem with detectors of this type is that they are not capable of differentiating the presence of a human from the presence of another type of objects normally found in public bathrooms, such as papers, plastics, remnants of dirt, or even living things, such as insects or small rodents.

These problems cause the current systems to be rather unhygienic, to offer a multitude of false positives, with the subsequent water wastage, and most importantly, they are not capable of allowing the establishment of predictive and corrective maintenance if an incident is detected in the bathroom.

Another important point to consider is that current apparatus generally requires the user to be very close to the sensor, practically in contact with it, with the metal surfaces in installations of this type being a source for the spread of pathogens. Therefore, it would be desirable for the sensors to be able to detect the user from a sufficient distance to prevent any possibility of spread due to contact.

On the other hand, in another type of typical fluid distribution installations, such as the pipe networks present in the petrochemical industry or in public potable water distribution networks, no system has been described for management, control, and predictive maintenance which allows knowing precisely the situation of the pipe in real time, detecting any type of leak, differences in the passage fluid, or any changes in the pipe network due to any incident such as those described above for damp rooms.

### Summary of the invention

The object of the present invention is a system for management, control, and predictive maintenance in installations in damp rooms and fluid distribution networks which, by means of using controlled electromagnetic field (CEMF) technology, allows differentiating human presence from any other presence, as well as informing of any incident that may occur in damp rooms and/or fluid distribution networks, as well as establishing the corrective measures to that end, all this being in accordance with the apparatus of claim 1. Particular embodiments of the apparatus of the invention are described in the claims depending on claim 1. Other aspects of the invention are described in independent embodiments.

The present invention therefore has the particularity of providing at least one CEMF sensor in each element to be controlled of an installation in damp rooms such as, for example, in a urinal, a sink, a hand dryer, or a bowl, although it could be implemented in any element present in a damp room, such as a paper dispenser, a soap dispenser, the electrical installation, or any other element. In this aspect, it must be pointed out that one sensor can be used for each damp room or area, or one sensor can be used for each element, both solutions being indifferent in this aspect.

The use in fluid distribution installations such as those found in damp rooms for public and/or private use has been described in the form of a non-limiting example. However, other uses are also described, such as the control of the passage of fluids in pipe networks by means of measuring the pressure and/or the type of fluid inside the pipe as a result of the CEMF sensor and being useful in the petrochemical industry or in public water distribution networks.

The apparatus has a simple operating principle. The apparatus essentially comprises an oscillator circuit generating a sine wave (alternating current) and the output of which is connected to at least one antenna arranged in the elements of the damp room, preferably integrated therein. The circuit has the particularity of being a closed loop since the signal of the antenna is in turn configured as an input signal of the oscillator circuit. This configuration allows following the signal of the antenna, i.e., when there is a disruption and the field magnitude changes, this change will immediately affect the oscillator circuit input, whereby the sensitivity of the apparatus is significantly increased, and the conventional emitter-receiver configuration described in the state of the art also becomes unnecessary. Another important advantage is that said configuration is not affected by external noises, given that the closed-loop configuration logically cancels the noises that may exist in the signal. This closed-loop configuration, already described in document EP2980609 or document EP3553477 belonging to the same applicant, is applied in an environment that is particularly hostile for electronic systems, such as damp rooms, particularly bathrooms for public and/or private use, which are logically damp and dirty environments with a multitude of particularities which are resolved according to the present invention.

The basis of CEMF technology applied by the present invention stems from the fact that the human body, like any other existing object, has its own dielectric characteristics, dependent on materials, density, volume, temperature, and conductivity. The differences in potential between different objects cause a plurality of electrostatic interactions of one object with another when they come into contact with or are close to one another. This effect generates fluctuations in the electromagnetic field around the antenna, which are continuously measured by the apparatus. Precisely, the measurement of this signal of the antenna, that is, the measurement of the change in impedance of the antenna due to a disruption, in turn molds the controlled electric and magnetic field around the antenna and allows determining which object has caused said disruption, that is, a person, an animal, or an inanimate object, depending on the change in impedance produced.

Therefore, as a result of the present invention a CEMF sensor can be installed in different elements typical of a damp room, for example a bathroom for public and/or private use, such as a urinal, a sink, a dryer, or a bowl, such that not only is the presence of persons detected, but it is also capable of detecting a clogged drain, for example, by detecting the increase in the water level, and cutting off water supply. It will also be capable of detecting the presence of elements that are not common in damp rooms, for example, detecting plastics, powder, or foreign objects, performing all this by means of an invisible system integrated in the element of the damp room, which allows preventing false positives in presence detection, with the subsequent water savings, and therefore allows establishing preventive maintenance for the entire system.

The scope of the present invention is defined by the claims. Throughout the description and claims, the word "comprises" and variants thereof do not intend to exclude other technical features, components, or steps. For those skilled in the art, other objects, advantages, and features of the invention will be inferred in part from the description and in part from the practice of the invention. The following usage examples and associated figures are provided in an illustrative and non-limiting manner. Furthermore, the present invention covers all the possible combinations of particular and preferred embodiments herein indicated.

### Brief description of the drawings

A series of drawings and diagrams which help to better understand the invention and are expressly related to an embodiment of said invention, provided as a non-limiting example thereof, are very briefly described below.
Figure 1 shows a diagram of the CEMF sensor implemented in the system for management, control, and predictive maintenance in installations in a damp room, for example a bathroom, object of the present invention.
Figure 2 shows a diagram of the system for management, control, and predictive maintenance in installations in damp rooms, object of the present invention.
Figure 3 shows a schematic view of a urinal implementing the system of the invention.
Figure 4 shows a schematic view of a bowl implementing the system of the invention.
Figure 5 shows a schematic view of a sink implementing the system of the invention.
Figure 6 shows a schematic view of a hand dryer implementing the system of the present invention.
Figure 7 shows a schematic view of a pipe installation implementing the system of the present invention.

### Detailed description of an embodiment of the invention

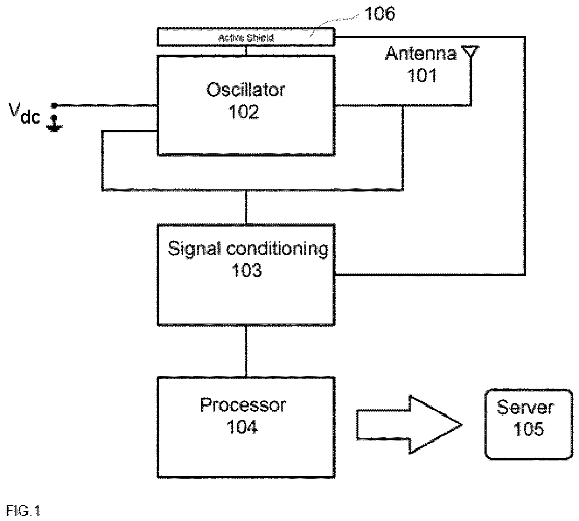

The invention is based on the implementation of CEMF technology described in documents EP2980609 and/or EP3553477 and the indications of which are herein by reference. Therefore, as can be observed in **Figure 1****,** the CEMF sensor 100 is based on an antenna 101, 101a, 101b, 101c, 101d, 101e which is connected with an oscillator circuit 102. The particularity of the CEMF sensor is that both the output and the input of the oscillator 102 are connected with the same antenna 101, such that the signal of the antenna 101 is feedback to the oscillator 102 itself. In other words, the emission of the signal of the oscillator 102 is proportional to the disruptions detected in the antenna 101, given that said disruptions are configured as the input of the oscillator circuit 102.

On the other hand, the same input signal of the oscillator 102 is acquired by a processor 104 through an analog-to-digital converter 103. The processor 104 further comprises a memory or memories storing a program or programs made up of instructions which, when run by the processor 104, cause the CEMF sensor 100 to: (a) continuously acquire the signal generated around the antenna 101; (b) establish a behavioral pattern corresponding with the acquired signal, and (c) send the behavioral pattern corresponding with the acquired signal to an external server 105 together with an identifier code of the antenna 101a...101e which has detected the disruption. The behavioral pattern can be sent to the server 105 in a continuous manner, with all the identified patterns being sent, or in a discrete manner, with only the patterns identified as erroneous patterns being sent. In another practical embodiment, the behavioral pattern could also be processed autonomously in the local processor and only an error code would be sent.

The external server 105 will be in charge of fusing data originating from the different sensors 100 positioned in different physical locations. Through the data fusion, it is therefore possible to establish preventive and/or corrective actions depending on the detected disruption.

One of the virtues of the present invention is that it can emit the electromagnetic field in a controlled manner by means of an active shield 106 by means of a low-impedance circuit, such that, through the only conducting element forming the emitting-receiving antenna, the electromagnetic field can be directed towards an area of influence that can be determined and configured for each specific application, as will be described hereinbelow.

As a result of this structure, the apparatus is capable of distinguishing, depending on the magnitude of change, i.e., depending on the generated disruption, if a person, an animal, or any other object is present, given that the invention is based on the capacity of the apparatus for measuring the variations of the electromagnetic field existing around each of the antennas to which the apparatus is connected, since the apparatus can be connected with several antennas, with the particularity that each of the antennas acts independently with respect to the others, i.e., each antenna has the same capabilities and functionalities in detecting the disruption, emits a controlled electromagnetic field, and in turn detects the disruptions of that field.

As indicated, the server 105 can establish preventive and/or corrective actions on the detected disruption. The versatility of the sensor 100 allows it to detect any foreign object and not only the presence of persons, as in the documents of the state of the art. In that sense, a sensor 100 located in a damp public room can detect, for example, the presence of insects or rodents. A blockage problem in the urinal or sink can also be detected through the continuous measurement of the electromagnetic and electric field around each antenna 101a...101e due to, for example, the detection of a foreign object, i.e., a plastic, a piece of paper, or the change in the disruption which entails a continuous increase in the water level. Another point to be considered is that the sensor 100 can detect the dripping or loss of water continuously, which can result in significant savings in water resources and a considerable reduction of costs of the installations. As a result of this structure, corrective measures, for example, closing the passage of water in a specific area or informing the cleaning staff, can be established from the server 105.

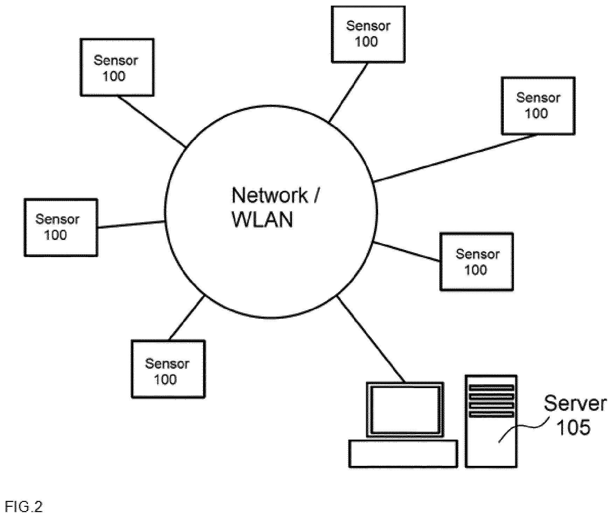

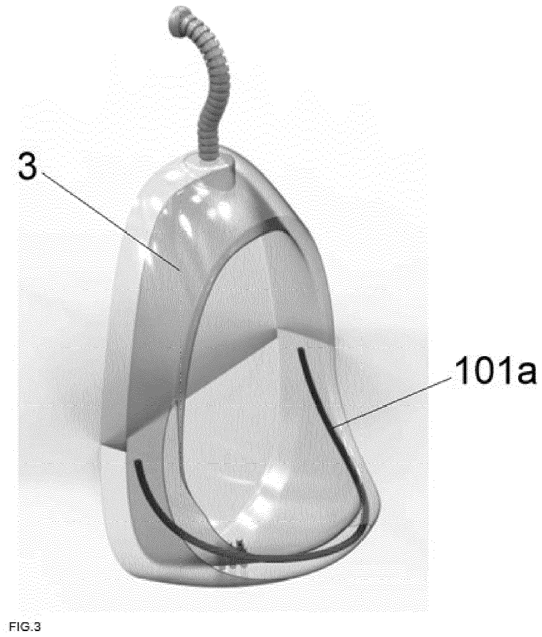

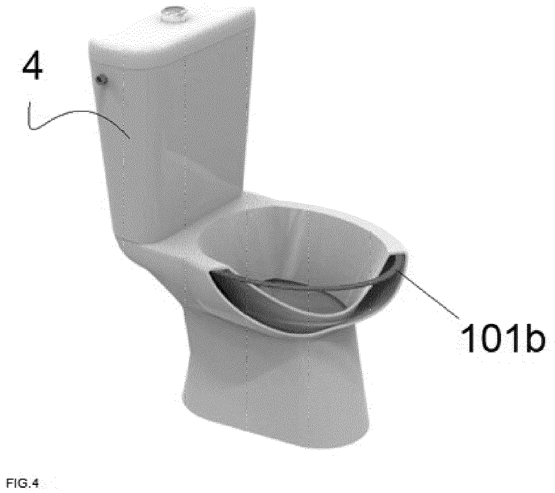

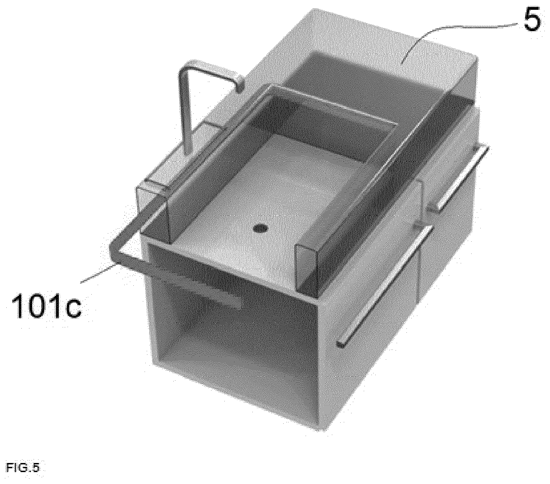

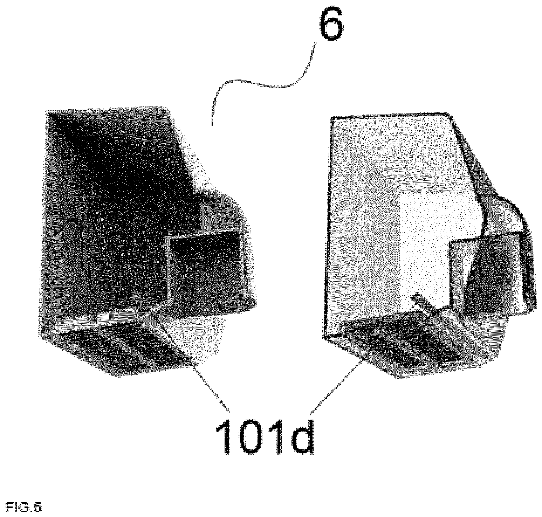

**Figure 2** shows the distributed diagram of the system for control and predictive maintenance in damp rooms for public and/or private use, object of the present invention. In that sense, a plurality of sensors 100a... 100e can be observed, wherein each of the sensors is attached to a specific antenna 101a...101e arranged in different elements of a damp room, such as a urinal, Figure 3, a bowl, Figure 4, a sink, Figure 5, or a hand dryer, Figure 6. The distribution of the antennas 101a...101e is very important, as will be explained below in reference to Figures 3 to 6. On the other hand, it is important to indicate that the structure of the sensor 100 may vary, including a plurality of antennas 101a... 101e, each connected with an oscillator circuit 102. The input signal of the oscillator circuit 102 will be connected with different analog-to-digital convertor circuits 103 and from these to a single processor 105 which will receive the signal of each of the antennas 101a...101e.

As indicated, the distribution of the antennas 101a...101e in each of the elements of the damp room is very important. In **Figure 3** it can be seen how the antenna 101a is integrated in the body of the urinal 3. The antenna 101a is materialized in a metallic strip which is housed inside the lower area of the body of the urinal 3. Therefore, it is completely invisible, and therefore tamper-proof, and allows disruption detection ranges of up to 1.5 meters. When a person approaches, it generates a disruption in the electromagnetic field generated around the antenna 101a and actuates the water mechanism when the person moves away. Nevertheless, that is only its normal use. Given the sensitivity of the sensor 100, the disruption is also different when water falls at an abnormal rate, when there are foreign objects, such as paper, plastics, or others, or when the water level increases without emptying. In other words, in the sensor 100 since establishing the type of disruption seeks not only to compare signals one by one, but rather characterizes typical data sequences or situations. For example, a typical situation consists of going from "no detection" to "detection of a person," from there to the "detection of water falling" and finally "the person moving away" and "not water falling". The occurrence of a failure in the detections typical of that sequence evidently points to an error in urinal 3, so the server 105 can identify the preventive and/or corrective measure suitable for each identified error. For example, the measures to be taken are not the same when a person is detected and water is not falling, that is, an error due to the water being shut off, for example, as when a continuous fall of water is detected without any presence, due to the breakage of the shut-off cock, or a detection of any other type.

In the application in a bowl 4 shown in **Figure 4****,** the present invention is essentially applied in a manner like the urinals 3. In that sense, the antenna 101b surrounds the upper portion of the bowl 4, creating an electromagnetic field around same for detecting a person sitting on the bowl 4. In normal operation, when the person gets up and moves away from the bowl 4, the sensor 100 activates the passage of water from the cistern 41. Again, and like in the preceding case, the advantage of the invention does not lie in the presence detection, but rather in the identification of behavioral patterns of the person and of the bowl 4 which can lead to different preventive or corrective actions depending on the identified failure. For example, it is possible to detect if the person has been sitting on the cover 42 and not on the bowl itself, so it becomes unnecessary to enable the passage of water. It is also possible to detect fouling on the upper edge of the bowl 4 or a blockage caused by paper or the like, which may involve automatically informing cleaning services and, where appropriate and if it is implemented in this manner, provided that the presence of a person is not detected, shutting down said bowl by means of closing the door for accessing same until the cleaning staff enables it.

In the application in a sink 5 shown in **Figure 5****,** the antenna 101c completely surrounds the outer upper edge of the sink 5 to create an electromagnetic field around the sink 5. It is therefore possible for the passage of water through the faucet 51 to be enabled when the user arrives and makes contact, and the mentioned faucet 51 turns off when the user removes his/her hands, resulting in a hygienic system. Like in the cases described in Figures 3 or 4, the usefulness and advantage of the system does not lie in the mere detection, but rather in the recognition of behavioral patterns typical of a user of a sink, such that proper use or improper or erroneous use of the element is established. For example, the typical sequence is "moving hands closer" - "turning the faucet on" - "removing hands" - "turning the faucet off'. The antenna 101c will detect any disruption in the field created around same which corresponds with those actions. Nevertheless, if any of those steps fails or unforeseen events arise, such as the detection of a foreign element like paper or plastic in the sink itself, it can generate different corrective or preventive actions. Even though the preceding sequence is carried out, if the sensor 100 detects a disruption that can be classified as an additional disruption, such as the presence of a large amount of paper in the sink 5, it can cause the faucet 51 to not turn on or water outflow to be regulated to prevent further blockage. In certain applications, a type of user notification display requesting the removal of the paper and/or justifying the absence of water in the faucet 51 may even exist.

In the application in hand dryers 6 shown in **Figure 6****,** there is basically an antenna 101d surrounding the lower portion thereof, at the hot air outlet. The advantages described in Figures 3 to 5 are the same for the hand dryer as it relates to an invisible and tamper-proof system which allows behavioral pattern detection and not only presence detection, which is a small part of the behavioral pattern, due to the changes that different actions generate in the electromagnetic field around the antenna 101d and which in turn cause different corrective or preventive responses from the server 105.

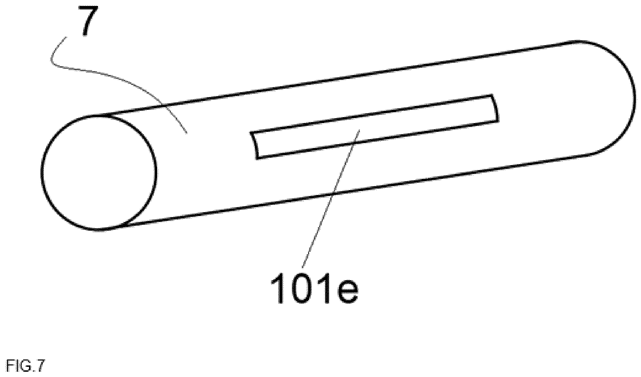

Finally, **Figure 7** shows an application in a pipe network of the type used in the petrochemical industry or in a public potable water management network. In this application, there is essentially an antenna 101e surrounding the pipe 7. The advantages described for the preceding examples are reproduced in this embodiment as it relates to an invisible, tamper-proof, and easy-to-implement system which allows detecting the pressure of the passage of fluid and any minimum change in said pressure, such that any unexpected change in pressure due to changes that different actions generate in the electromagnetic field around the antenna 101e and which in turn cause different corrective or preventive responses from the server 105 can be established and characterized.

## Claims

1. A method for management, control, and predictive maintenance in installations in damp rooms and fluid distribution networks, comprising the steps of:
integrating an antenna (101, 101a...101e) inside at least one element installed in a damp room and/or fluid distribution network (3, 4, 5, 6, 7), wherein said antenna (101, 101a...101e) is configured for receiving the signal of an electromagnetic field generated around same; and wherein said antenna (101, 101a... 101e) is connected with at least one controlled electromagnetic field sensor (100) configured for generating an electric and magnetic field around said antenna (101, 101a...101e);
continuously measuring the variations in the electric and magnetic field generated around the antenna (101, 101a... 101e);
establishing a behavioral pattern of the installation in an element installed in a damp room and/or fluid distribution network (3, 4, 5, 6, 7) corresponding with a disruption in the electric and magnetic field generated around the antenna (101, 101a...101e); and
selecting an action to be performed in the element installed in a damp room and/or fluid distribution network (3, 4, 5, 6, 7) depending on the established behavioral pattern.

2. The method according to claim 1, wherein the element installed in a damp room and/or fluid distribution network (3, 4, 5, 6, 7) is at least one selected from: a urinal (3), a bowl (4), a sink (5), a hand dryer (6), or a pipe (7).

3. The method according to one of claims 1 or 2, wherein the antenna is a metallic part connected with an oscillator (102) of the controlled electromagnetic field sensor (100).

4. The method according to one of claims 1 or 2, wherein the antenna is a metallic region of the element installed in a damp room and/or fluid distribution network (3, 4, 5, 6, 7).

5. A system for control and predictive maintenance in installations in damp rooms and fluid distribution networks, comprising:
an element installed in a damp room and/or fluid distribution network (3, 4, 5, 6, 7) integrating an antenna (101, 101a...101e) therein, and wherein said antenna (101, 101a... 101e) is connected with at least one controlled electromagnetic field sensor (100) configured for generating an electric and magnetic field around said antenna (101, 101a...101e);
wherein the controlled electromagnetic field sensor (100) comprises at least one oscillator (102) connected with the antenna (101, 101a...101e) such that the signal of the antenna (101, 101a...101e) is feedback as input to the oscillator (102); and wherein the input signal of the oscillator (102) is acquired by a processor (104) through an analog-to-digital converter (103); and
**characterized in that** the processor (104) comprises a memory or memories storing a program or programs made up of instructions which, when run by the processor (104), cause the sensor (100) to:
(a) continuously acquire the signal generated around the antenna (101, 101a...101e);
(b) establish a behavioral pattern corresponding with the acquired signal corresponding with a disruption in the electromagnetic field generated around the antenna (101, 101a...101e).

6. The system according to claim 5, wherein the processor (104) comprises a memory or memories storing a program or programs made up of instructions which, when run by the processor (104), cause the sensor (100) to send the behavioral pattern corresponding with the acquired signal to an external server (105) together with an identifier code of the antenna (101, 101a...101e) which has detected the disruption.

7. The system according to claim 5, wherein the processor (104) comprises a memory or memories storing a program or programs made up of instructions which, when run by the processor (104), cause the sensor (100) to locally analyze said pattern and send an identification code of the analysis to the external server (105).

8. The system according to claim 5, wherein the external server (105) is configured for fusing data originating at least from a plurality of sensors (100) positioned in different physical locations.

9. The system according to one of claims 5 to 8, wherein the element installed in a damp room and/or fluid distribution network (3, 4, 5, 6, 7) is at least one selected from: a urinal (3), a bowl (4), a sink (5), a hand dryer (6), or a pipe (7).

10. The system according to one of claims 5 to 9, wherein the antenna is a metallic part connected with the oscillator (102) of the controlled electromagnetic field sensor (100).

11. The system according to one of claims 5 to 9, wherein the antenna is a metallic region of the element installed in a damp room and/or fluid distribution network (3, 4, 5, 6, 7).
